# EUROPEAN PATENT APPLICATION

(11) **EP 2 739 125 A1**
(43) Date of publication of application: **04.06.2014**
(21) Application number: 12194674.3
(22) Date of filing: 28.11.2012
(51) Int. Cl.: H05K 1/02, H05K 3/36, H05K 1/11

(54) **Electrical connection interface for connecting electrical leads for high speed data transmission**

(71) Applicant: Tyco Electronics Svenska Holdings AB, 17526 Järfälla (SE); Tyco Electronics Japan G.K., Takatsu-ku Kawasaki-shi Kagawa 213-8535 (JP)
(72) Inventor: Kaikkonen, Andrei, 17548 Järfälla (SE); Lapidot, Doron, Setagaya-ku, Tokyo 158-0081 (JP); Lundqvist, Lennart Per Olof, 17760 Järfälla (SE); Svensson, Lars-Göte, 19133 Sollentuna (SE)
(74) Representative: Grünecker, Kinkeldey, Stockmair & Schwanhäusser

(57) **Abstract**

The present invention relates to an electrical connection interface for connecting electrical leads for high speed data transmission, comprising a first substrate carrying at least one first electrically conductive lead (102, 102') having an interface region connected to at least one second electrically conductive lead (104, 104'), and at least one first ground plane layer (106, 106'). A second substrate carries the at least one second electrically conductive lead having an interface region connected to the at least one first electrically conductive lead, and at least one second ground plane layer (108, 108'). The electrically conductive leads are arranged on adjacent surfaces of the substrates. The ground plane layers (106, 106'; 108, 108') are electrically insulated from the respective conductive leads and are arranged to at least partly overlap each other.

## Description

The present invention relates to an electrical connection interface for connecting electrical leads for high speed data transmission. The present invention is in particular focused on board-to-board interconnects.

Due to the high data rates in recently developed communication systems having data transmission rates of e. g. 25 Gbps, signal integrity, such as for instance the reduction of cross-talk between signal lines, has become a major concern.

Ideally, an interconnection system will carry signals without distortion. One type of distortion is called cross-talk. Cross-talk occurs when one signal creates an unwanted signal on another signal line. Generally, cross-talk is caused by electromagnetic coupling between signal lines. Therefore, cross-talk is a particular problem for high-speed, high-density interconnection systems. Electromagnetic coupling increases when signal lines are closer together or when the signals they carry are of a higher frequency. Both of these conditions are present in a high-speed, high-density interconnection system. Discontinuities in the connector often exacerbate any cross-talk problems. It is known to insert a shielding into the connectors in the connection system in order to reduce the impact of cross-talk.

Furthermore, it is known to use differential signals for transporting information. One differential signal is carried on two conductors, with the signal being represented as the difference in electrical levels between the conductors. A differential signal is more resistant to cross-talk than a single-ended signal, because any stray signals impinging on the conductors will generally change the level on both conductors, but do not alter the difference in levels.

Consequently, conventional high-speed transmission assemblies use circuit boards as a substrate to be connected to another board having a pair of wires for carrying each differential signal. A first printed circuit board has traces and pads on at least one of its surfaces, wherein particular contact pads are to be contacted by being soldered to mating contact pads on a second printed circuit board. The traces transmit electrical signals across the respective first and second printed circuit boards.

The transition from the first printed circuit board to the second printed circuit board of course needs to be capable of handling the high data rates as well. Moreover, due to the small form factor of the interconnect, cross-talk between adjacent or even further remote pairs of lines is an important parameter. Ground plane layers are typically used for shielding the lines against signal distortions.

However, at the electrical connection interface where two printed circuit boards are soldered, impedance compensation has to be used in order avoid distortions of the signal due to signal reflection. Therefore, conventional electrical connection interfaces dispense with internal ground layers in the particular region where the conductive pads of the traces are soldered to each other. An electrical connection between the ground plane layers of the first and second printed circuit board is established by providing ground-to-ground interconnecting leads that extend over the ground plane free gap. The size of such a board-to-board interconnect can be rather significant, typically 1200 µm per differential pair of signals, considering current reflow soldering technology allowing minimum 200 µm spacing between solder balls and restricting solder ball width to 200 µm.

Thereby, however, cross-talk between the signal lines and other effects degrading the signal integrity are no longer eliminated effectively enough.

The object underlying the present invention therefore is to improve a high-speed board-to-board connection interface with regard to signal integrity and cross-talk reduction, at the same time maintaining the small form factor and the cost-effective construction. This object is solved by the subject matter of the independent claims. Advantageous developments of the inventive connection interface element are the subject matter of the dependent claims.

The invention is based on the finding that by arranging the ground plane layers of two circuit boards which have to be interconnected in a way that they at least partially overlap each other, in particular in the region of the electrical connection interface, a smooth transition of the differential pair of signals via a short strip line can be achieved. The interconnect performance can be improved, and by allowing to reduce the number of ground-to-ground interconnects also the total interconnect size can be reduced.

In particular, an electrical connection interface for connecting electrical leads for high-speed data transmission according to the present invention comprises a first substrate carrying at least one first electrically conductive lead having an interface region connected to at least one second electrically conductive lead. The first substrate further comprises at least one first ground plane layer. A second substrate carries the at least one second electrically conductive lead and at least one second ground plane layer.

The first and second electrically conductive leads are arranged on adjacent surfaces of the first and second substrates, respectively. The at least one first ground plane layer is arranged to be electrically insulated from the at least one first conductive layer and the second ground plane layer is electrically insulated from the at least one second conductive lead. The first and the second ground plane layers are arranged to at least partially overlap each other.

According to an advantageous embodiment, at least one of the first and second ground plane layers is provided with at least one clearance. By providing such a clearance in a region adjacent to the transition interface between the first and second electrically conductive leads on the two substrates, and thereby only leaving narrow strips of grounding layer in a peripheral region of same, cross-talk is reduced along with mode conversion level. At the same time, the differential impedance at the interface is influenced only to a negligible extent, so that the electrical performance of the transition between the two circuit boards are maintained.

In particular, measured in a direction along the conductive leads, the grounding strip at the margin of at least one printed circuit board has a dimension of less than ten percent of the dimension of the interface region. This ensures a particularly small influence on the impedance matching between the first and second leads.

Furthermore, when providing a plurality of electrical leads and accordingly a plurality of clearances, same can be separated from each other by a grounding web. In order to further improve the common mode impedance and the mode conversion, a further strip of conducting line forming an additional grounding web can be introduced in the clearance overlying a pair of connected signal lines, so that individual leads of one pair of electrical leads are separated from each other.

By designing this separating grounding web to have a tapered region adjacent to that area of the conductive leads having a smaller width than in the region of their pads, the self-inductance can be reduced. On the other hand, of course the electrical leads can also be arranged to be in the vicinity of one common clearance per pair of conductive leads.

The present invention can be advantageously employed for interconnecting all sorts of circuit carriers, such as printed circuit boards (PCB), flexible printed circuits (FPC), ceramic circuit carriers or any other suitable substrate. The first and second substrates to be connected may either be of the same kind or of a different kind. The ground plane layers can be formed by a structured copper layer within or on a surface of these circuit carriers.

According to the present invention, the first and second ground plane layers are electrically connected to each other by at least one contact point arranged in the overlapping area. This means that a direct contacting in the third dimension is performed, and no additional leads extending into the area of the signal leads have to be provided. This at least one contact point may either be located adjacent to the interface regions or also distanced from the interface region. The choice of the particular location will be guided by the restrictions that are imposed due to size or signal integrity. For instance, in systems where common mode impedance, mode conversion and cross-talk are very critical, the contact points can be located between the contact pads of the signal leads in a way that a so-called GSSG configuration is formed meaning that each pair of signal lines is separated form the adjacent one by a ground contact point. In order to meet more strict size constraints, however, also a GSSSSG configuration can be provided.

The accompanying drawings are incorporated into and form a part of the specification to illustrate several embodiments of the present invention. These drawings together with the description, serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combination-solutions according to the present invention. Further features and advantages will become apparent from the following more particular description of the various embodiments of the invention, as illustrated in the accompanying drawings, in which like references refer to like elements.
- **Fig.1**: shows a perspective view of a part of an electrical connection interface according to a first embodiment of the present invention;
- **Fig. 2**: shows a perspective view of a part of an electrical connection interface according to a second embodiment of the present invention;
- **Fig.3**: shows a perspective view of a part of an electrical connection interface according to a third embodiment of the present invention;
- **Fig. 4**: shows the differential mode impedance profile from the side of the first signal leads with a 15 ps 20% to 80% rise time for the embodiment of Fig. 1 at a nominal impedance of 90 Ω;
- **Fig. 5**: shows the return loss corresponding to the impedance profile of Fig. 4;
- **Fig. 6**: shows the common mode impedance profile from the side of the first signal leads with a 15 ps 20% to 80% rise time for the embodiment of Fig. 1 at a nominal impedance of 22.5 Ω;
- **Fig. 7**: shows the return loss corresponding to the impedance profile of Fig. 6;
- **Fig. 8**: shows the near end cross-talk and the far end cross-talk for the embodiment of Fig. 1;
- **Fig. 9**: shows the mode conversion for the interconnect shown in Fig. 1;
- **Fig. 10**: shows the differential mode impedance profile from the side of the first signal leads with a 15 ps 20% to 80% rise time at a nominal impedance of 90 Ω for the embodiment shown in Fig. 3;
- **Fig. 11**: shows the return loss corresponding to the impedance profile of Fig. 10;
- **Fig. 12**: shows the common mode impedance profile from the side of the first signal leads with a 15 ps 20% to 80% rise time at a nominal impedance of 22.5 Ω for the embodiment of Fig. 3;
- **Fig. 13**: shows the return loss corresponding to the impedance profile of Fig. 12;
- **Fig. 14**: shows the near and far end cross-talk for the interconnect shown in Fig. 3;
- **Fig. 15**: shows the mode conversion for the interconnect shown in Fig. 3;
- **Fig. 16**: shows a top view of an electrical connection interface according to a further advantageous embodiment;
- **Fig. 17**: shows the differential mode impedance profile from the FPC side with a 15 ps 20% to 80% rise time and a nominal impedance of 90 Ω for the embodiment shown in Fig. 16;
- **Fig. 18**: shows the return loss corresponding to the impedance profile of Fig. 17;
- **Fig. 19**: shows the common mode impedance profile from the FPC side with a 15 ps 20% to 80% rise time and a nominal impedance of 22.5 Ω for the embodiment shown in Fig. 16;
- **Fig. 20**: shows the return loss corresponding to the impedance profile of Fig. 19;
- **Fig. 21**: shows the near end and far end cross talk for the interconnect shown in Fig. 16;
- **Fig. 22**: shows the mode conversion for the interconnect according to the embodiment shown in Fig. 16.

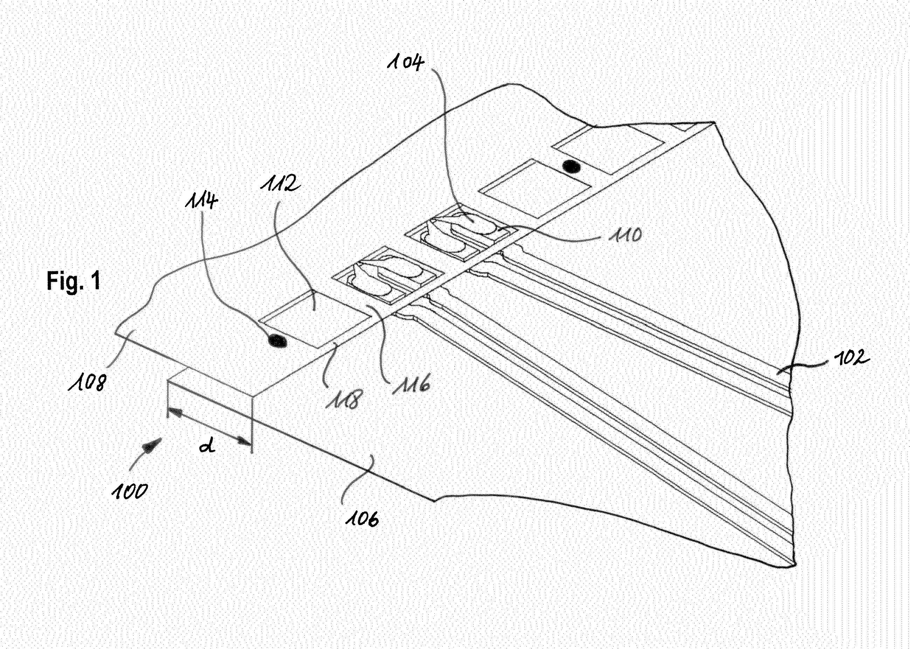

Referring now to FIG. 1, a first advantageous embodiment of an electrical connection interface 100 according to the present invention, is shown.

In Fig. 1, only the metallic parts, i. e. the signal leads and the ground plane layers, are shown in order to make clear the gist of the invention. However, of course, also insulating layers are present and furthermore, the shown metallic layers do not have to be the only electrically conductive layers. For instance, each printed circuit board may contain embedded active and passive components and ,furthermore, also more than two circuit boards can be stacked, interconnecting same by means of more than one electrical connection interface 100.

According to a basic embodiment of the present invention as shown in Fig. 1, the electrical connection interface 100 is used for connecting two printed circuit boards (PCB).

A first substrate (not shown in the figure) carries two pairs of first electrically conductive leads. On the substrate of a second PCB (not shown in the figure) second electrically conductive leads 104 are provided. The shown number of leads is of course only intended to give a particular example. Any other desired number of electrically conductive leads is of course also possible.

As shown in Fig. 1, on the first PCB there is arranged a first ground plane layer 106. On the opposing second PCB, there is provided a second ground plane layer 108. Each of these ground plane layers are either located within the printed circuit board or situated on a surface opposing to the one where the respective electrically conductive leads 102, 104, are arranged.

According to the present invention, the ground plane layers 106, 108 overlap in the area of the electrical connection interface 100, as indicated by the distance d. The distance d may have dimensions of about 1 mm, when assuming a solder ball size of 500 µm x 200 µm x 80 µm. Each first electrically conductive lead 102 is connected to the corresponding second electrically conductive lead 104 by means of a solder ball 110. However, when providing an overlapping of the two ground plane layers 106, 108 according to the present invention, of course also other electrically conducting connection techniques, such as press fit pins can be used for connecting the signal leads. For establishing the solder connection, each first and second electrically conductive lead 102, 104 has a solder pad structure in the interface region.

In the shown embodiment, adjacent to each differential pair of solder pads, a clearance 112 is provided in the first ground plane layer 106. These clearances, which sometimes are also referred to as anti pads, are advantageously provided in order to adjust the differential impedance profile of the transmission lines. In Fig. 1, only two pairs of first and second electrically conductive leads 102, 104, are shown. However, there can be of course many more leads in parallel. In Fig. 1 an electrical connection between the first ground plane layer 106 and the second ground plane layer 108 is schematically represented by the connection points 114. There may for instance be provided solid ground interconnects as connection points 114 between the first and second ground plane layers every forth differential pair of signal pads. The solder balls 110 may have dimensions of 500 µm x 200 µm x 80 µm.

Furthermore, the two leads of each pair of the first electrically conductive leads 102 may be distanced apart by 200 µm, whereas the adjacent pairs are distanced apart for instance by 350 µm. The first and second electrically conductive leads 102, 104, may have a total length of for instance 11 mm and 3 mm, respectively.

As shown in Fig. 1, each of the clearances 112 is separated from an adjacent one by means of a grounding web 116 provided in the second ground plane layer 108. Furthermore, a cross-talk suppression strip 118 is formed at the margin of the second ground plane layer 108. By using this particular design, a two-fold effect can be achieved: firstly a part of the second ground layer 108 is still present in the interconnection area providing an effect equal to an ESD shield. On the other hand, to achieve the necessary impedance match and therefore to avoid signal reflection, a cut-out is present in a region where the first and second electrically leads 102 and 104 are connected to each other. Therefore, cross-talk components can be blocked while still maintaining an unaltered (or only marginally different) differential impedance.

In Fig. 1, only the second ground plane layer 108 is provided with clearances 112. However, of course additionally or alternatively such clearances can also be provided in the first ground plane layer 106.

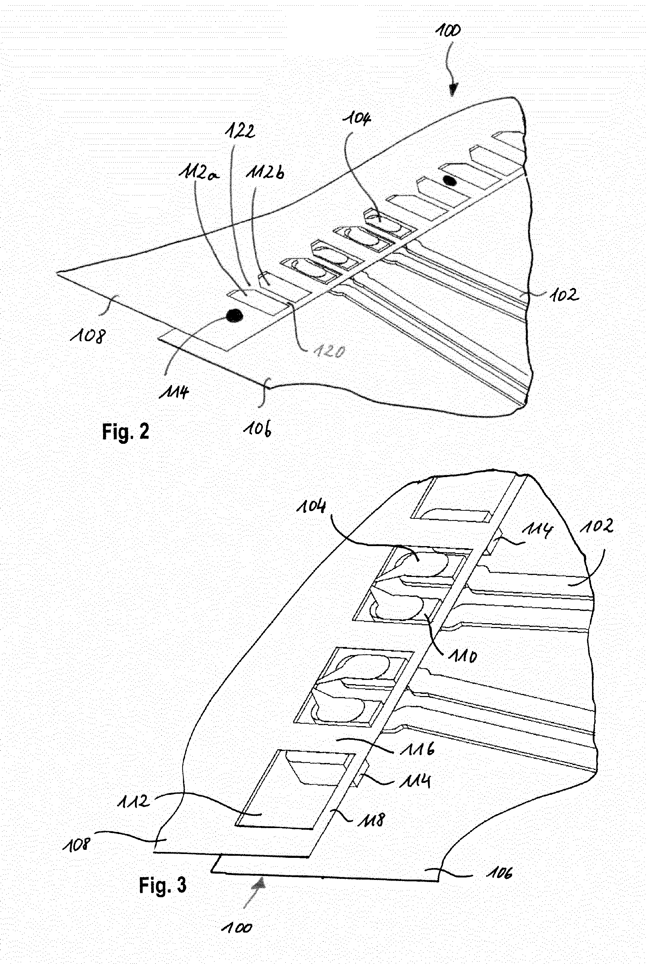

Fig. 2 shows a second advantageous embodiment of the electrical connection interface 100 according to the present invention. According to this embodiment, the second ground plane layer 108 is modified in that each of the clearances 112 of Fig. 1 is partitioned into two clearances 112a and 112b by an additional grounding web 120. By introducing such a short strip of conducting line in the middle of the clearance 112 between the two signal pads, a further improvement to the common mode impedance and the mode conversion can be achieved. In particular, the additional grounding web 120 is widened in the regions of the traces 104, where they escape and diverge to the solder pads. Such a tapered region 122 reduces the self-inductance and thus improves the signal integrity.

With the arrangement of Fig. 2 the connection between the first ground plane layer 106 and the second ground plane layer 108 may either be performed in a GSSSSG configuration or a GSSG configuration. The first configuration with fewer connection points 114 between the two ground plane layers has advantages in view of the necessary space, whereas providing more connection points is more advantageous in cases where common mode impedance, mode conversion and cross-talk are very critical.

In particular, Fig. 3 shows the more robust GSSG configuration with connection points 114 provided between every second differential pair of signal pads.

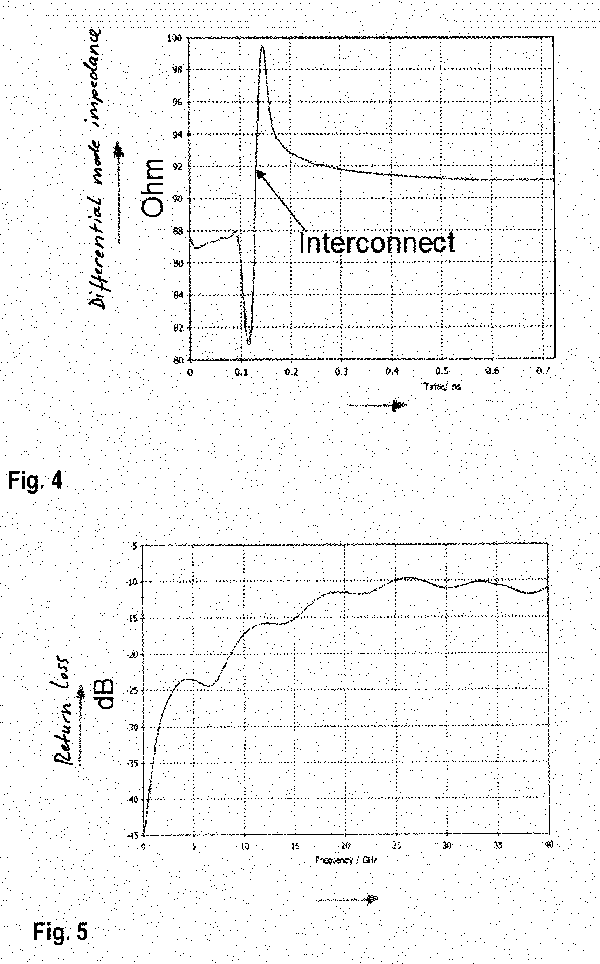

Figs. 4 to 9 illustrate the actual performance of the arrangement according to Fig. 1. In particular, Fig. 4 shows a differential mode impedance profile from the side of the first electrically conductive leads 102 for a 15 ps 20% to 80% rise time at a nominal impedance of 90 Ω. The return loss corresponding to the impedance profile of Fig. 4 is shown in Fig. 5.

Return loss is a frequency domain parameter analogous to the time domain impedance profile. Return loss (RL) is defined as the amount of signal energy reflected back towards the source as a result of impedance mismatches in the transmission path.

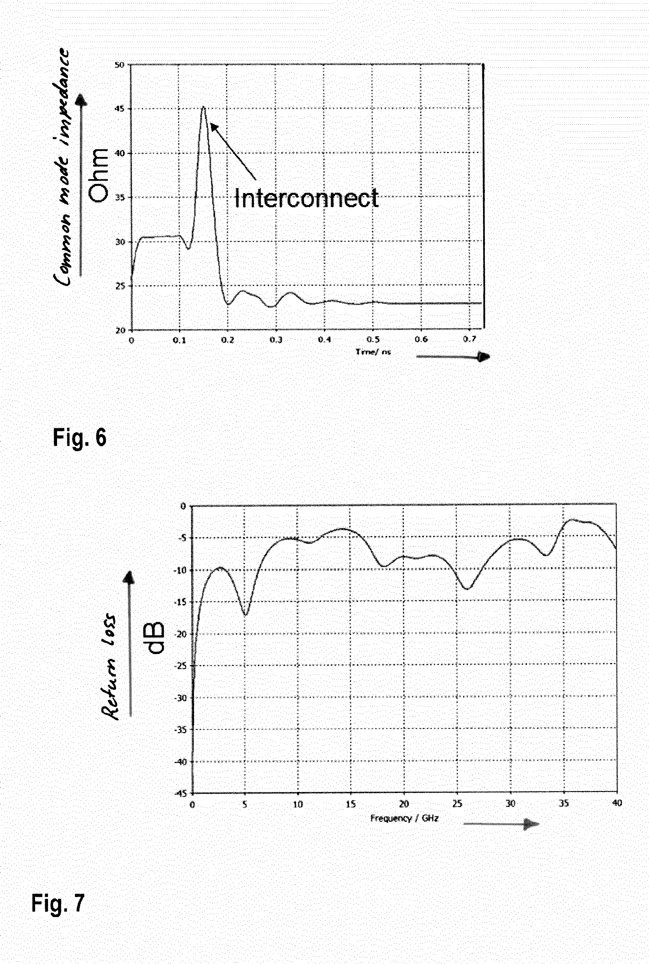

Further, Fig. 6 shows the common mode impedance profile from the side of the first signal leads with a 15 ps 20% to 80% rise time for the embodiment of Fig. 1 at a nominal impedance of 22.5 Ω. Fig. 7 shows the return loss corresponding to the impedance profile of Fig. 6.

As already indicated above, cross-talk is often a critical parameter to consider when selecting an interconnect for a high speed application. Cross-talk can be defined as noise arising from unwanted coupling of nearby signal lines. It occurs when two signals are partially superimposed on each other by inductive and capacitive coupling between the conductors carrying the signals. Cross-talk can result in distortion and degradation of the desired signals. There are two types of crosstalk of concern in high speed systems, near end (NEXT) and far end crosstalk (FEXT). NEXT is the measure of the level of crosstalk at the transmitting end of the signal path, while FEXT is the measure of crosstalk at the receiving end of the signal path.

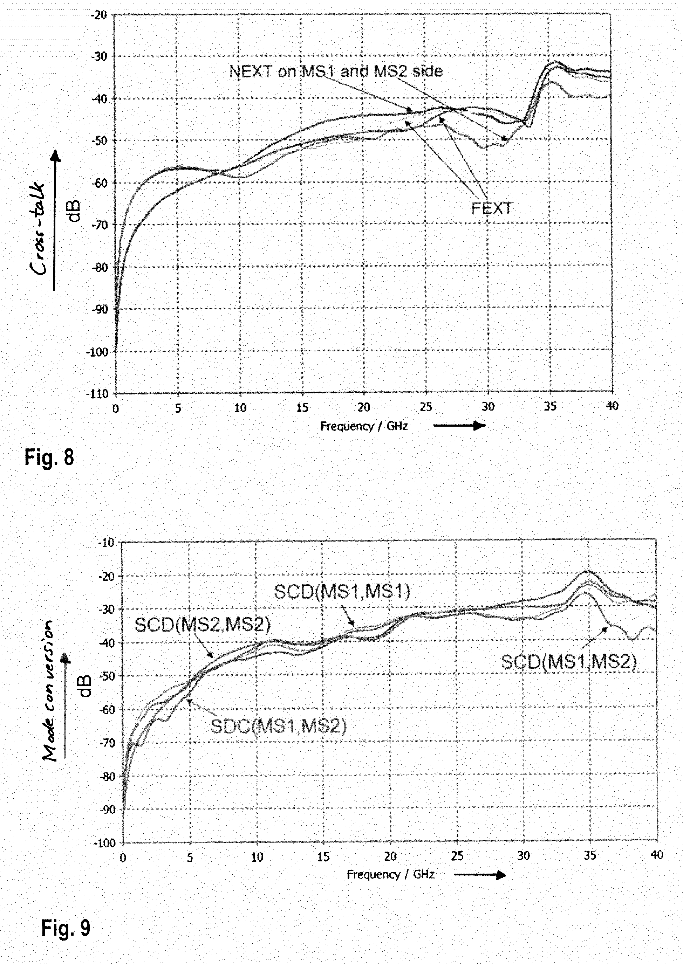

Fig. 8 shows the near end cross-talk and the far end cross-talk for the embodiment of Fig. 1 and Fig. 9 shows the mode conversion for the interconnect shown in Fig. 1. In these Figures, MS1 and MS2 signify the first and second electrically conductive leads, respectively. For the embodiment of Fig. 1, the insertion loss vs. cross-talk ratio is about 47 dB at 14 GHz and 30 dB at 35 GHz. As this is known to a person skilled in the art, a value of 30 dB corresponds to the typical transceiver dynamic range.

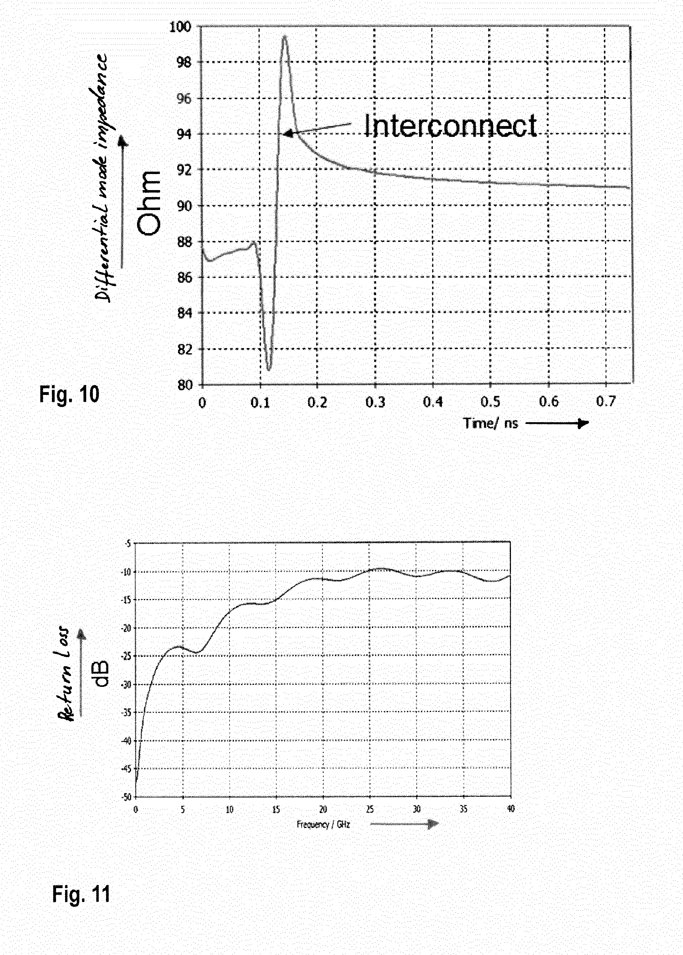

The performance of the arrangement according to Fig. 3 is illustrated in the measurement curves of Figures 10 to 15. Specifically, Fig. 10 shows the differential mode impedance profile from the side of the first signal leads with a 15 ps 20% to 80% rise time at a nominal impedance of 90 Ω for the embodiment shown in Fig. 32, and Fig. 11 shows the return loss corresponding to the impedance profile of Fig. 10.

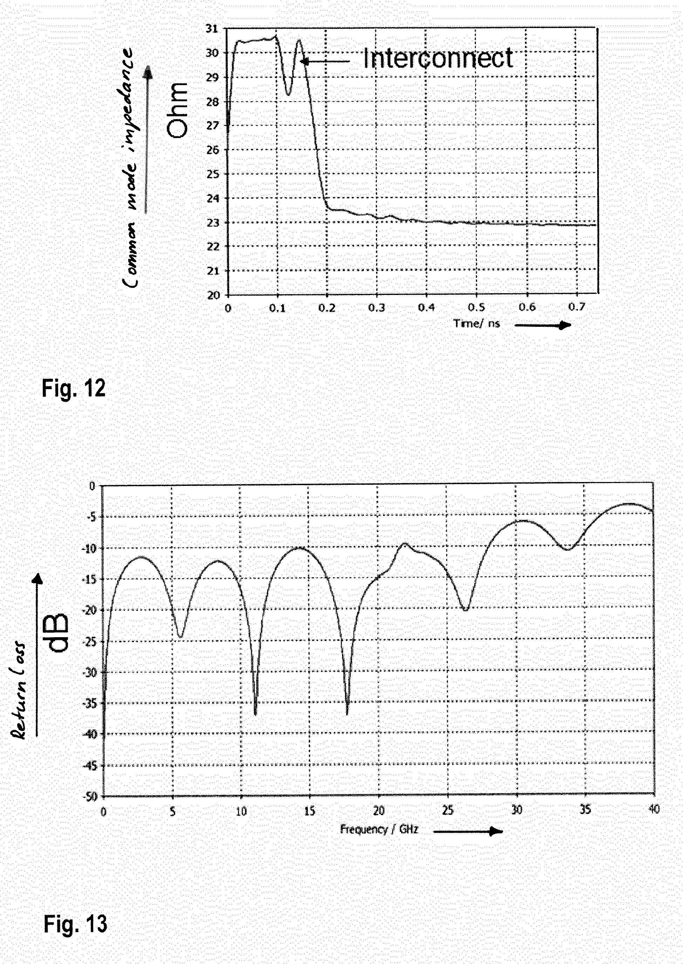

Further, Fig. 12 shows the common mode impedance profile from the side of the first signal leads with a 15 ps 20% to 80% rise time at a nominal impedance of 22.5 Ω for the embodiment of Fig. 3, and Fig. 13 shows the return loss corresponding to the impedance profile of Fig. 12.

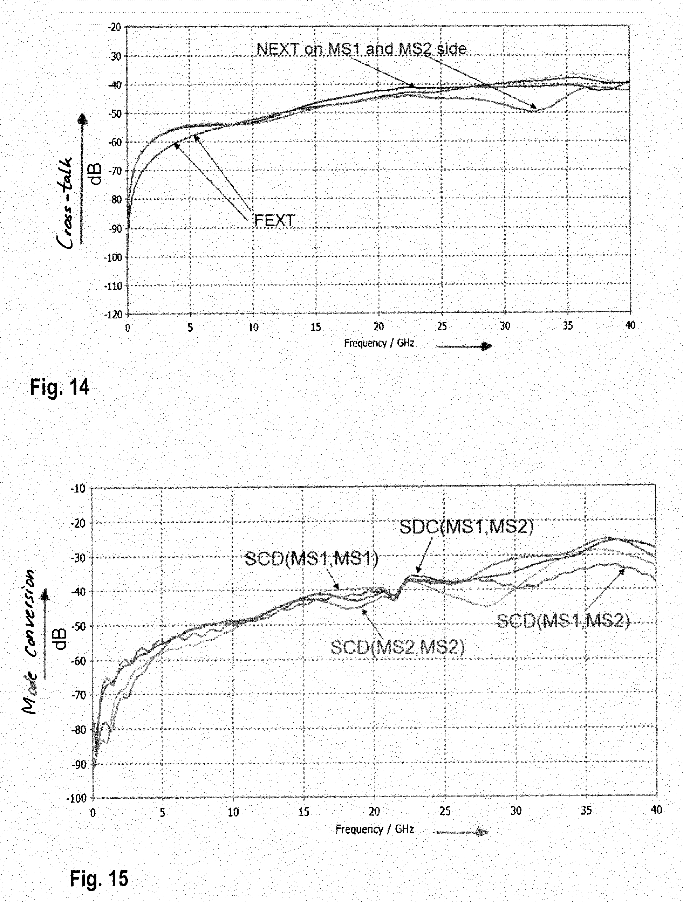

Fig. 14 shows the near and far end cross-talk for the interconnect shown in Fig. 3 and Fig. 15 shows the mode conversion for the interconnect shown in Fig. 3. For the arrangement according to Fig. 3, the insertion loss vs. cross-talk ratio is about 47 dB at 14 GHz and 30 dB for frequencies beyond 40 GHz.

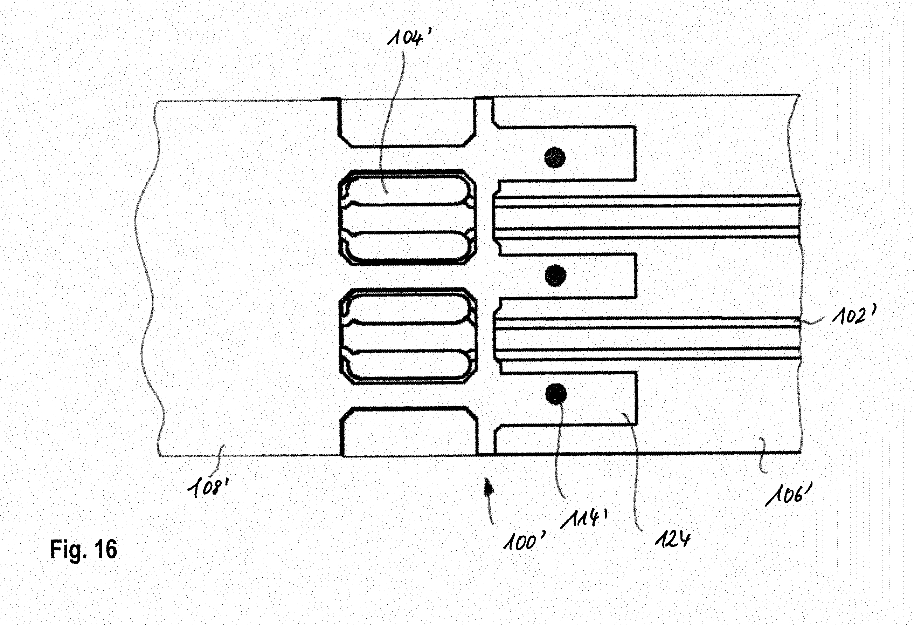

Fig. 16 shows in a top view a further advantageous embodiment of the present invention.

Again, a first printed circuit board is connected to a second substrate which in contrast to the previous embodiments of Figs. 1 to 3, however, is formed by a flexible printed circuit (FPC).

In Fig. 16 only the metallic parts are shown, in particular, the first ground plane layer 106' and the second ground plane layer 108' as well as the first and second electrically conductive leads 102' and 104', respectively. Similar to the embodiments shown in Figs. 1 to 3, clearances 112' are provided in the second ground plane layer 108' for performing an optimized impedance matching. In contrast to the previous embodiments, however, the connection points 114' between the first and second ground plane layers (106', 108') are not arranged in close vicinity of the clearances, but at a remote location formed by protruding fingers 124. This design also implies a much larger overlap distance d'.

The advantage of this particular embodiment can mainly been seen in the fact that a much more narrow design can be achieved. Furthermore, the mechanical stability of the FPC carrying the second ground plane layer 108' is enhanced thereby. The design according to Fig. 16 may advantageously be used for an FPC to PCB interconnect that is able to connect 12 channels transmitting data rates of 25 Gbps with a still satisfactory signal integrity.

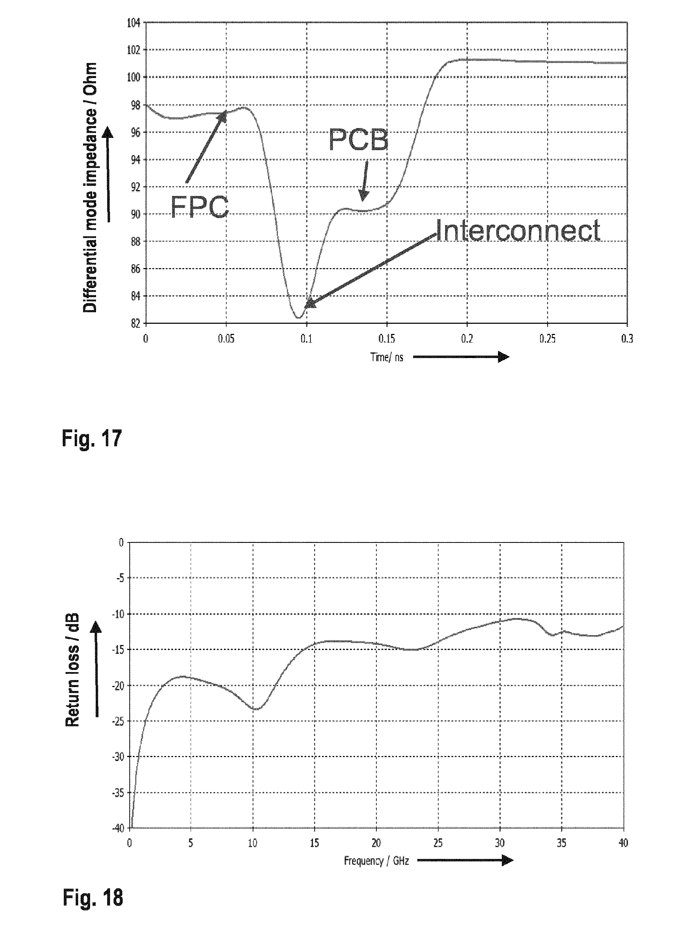

The actual performance of the arrangement according to Fig. 16 is illustrated in the measurement curves of Figures 17 to 23. Specifically, Fig. 17 shows the differential mode impedance profile from the FPC side with a 15 ps 20% to 80% rise time and a nominal impedance of 90 Ω for the embodiment shown in Fig. 16, and Fig. 18 shows the return loss corresponding to the impedance profile of Fig. 17.

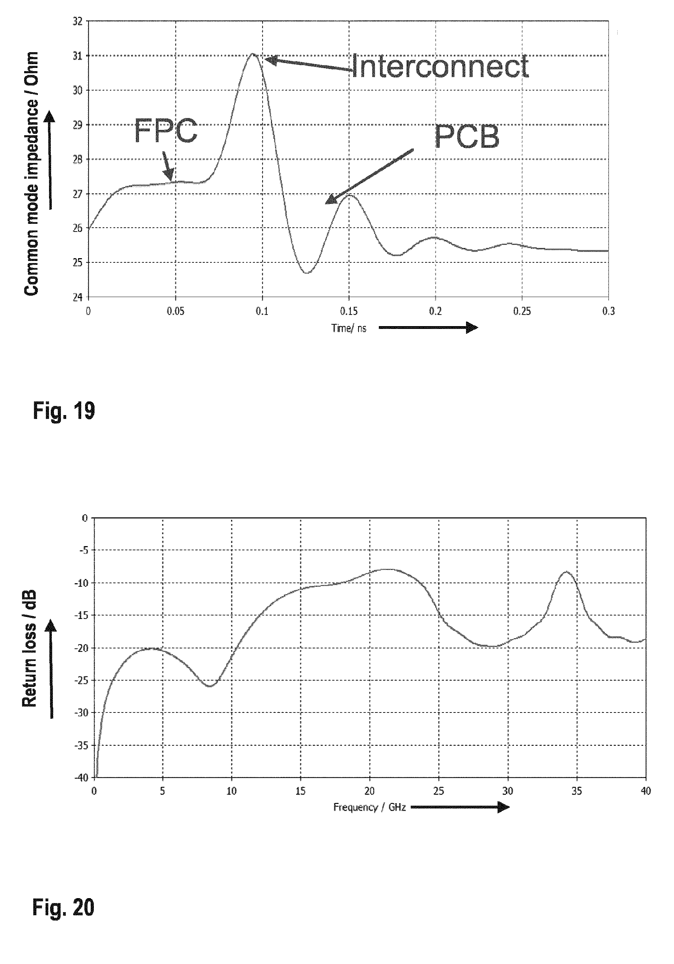

Fig. 19 shows the common mode impedance profile from the FPC side with a 15 ps 20% to 80% rise time and a nominal impedance of 22.5 Ω for the embodiment shown in Fig. 16, and Fig. 20 shows the return loss corresponding to the impedance profile of Fig. 19.

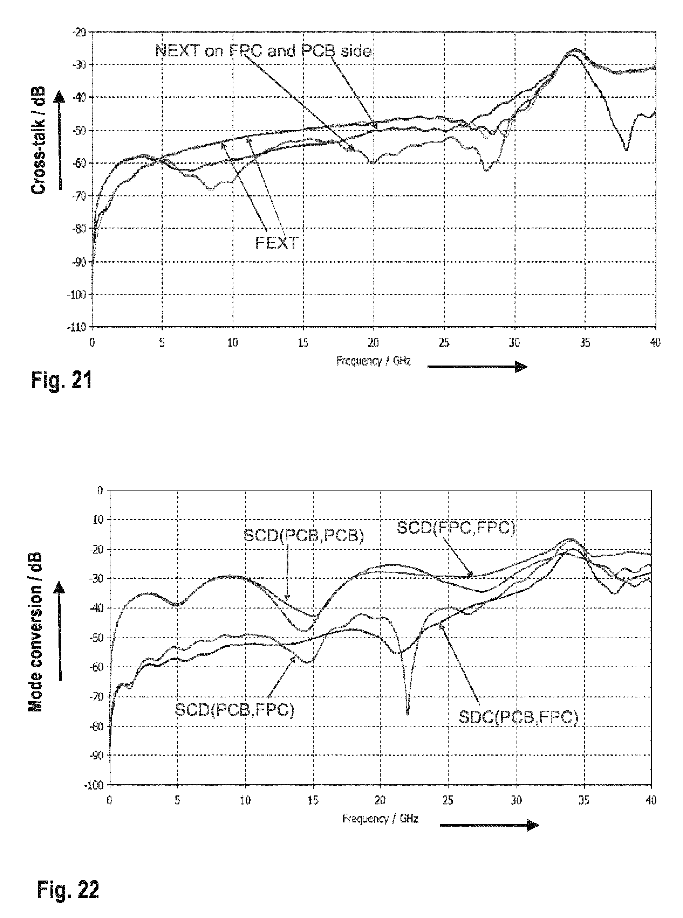

Fig. 21 shows the near end and far end cross talk for the interconnect shown in Fig. 16, and Fig. 22 shows the mode conversion for the interconnect according to the embodiment shown in Fig. 16. For the embodiment according to Fig. 16, the insertion loss vs. cross-talk ratio is about 49 dB at 14 GHz and 30 dB at 33 GHz.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

### Reference Numerals

| **Reference Numerals** | **Description** |
|---|---|
| 100, 100' | electrical connection interface |
| 102, 102' | first electrically conductive lead |
| 104, 104' | second electrically conductive lead |
| 106, 106' | first ground plane layer |
| 108, 108' | second ground plane layer |
| 110 | solder ball |
| 112, 112' | clearance |
| 114, 114' | connection point |
| 116 | grounding web |
| 118 | grounding strip for cross-talk suppression |
| 120 | additional grounding web |
| 122 | tapered region of additional grounding web |
| 124 | protruding contact finger |
| d, d' | overlap distance |

## Claims

1. Electrical connection interface for connecting electrical leads for high speed data transmission, said connection interface (100) comprising:
a first substrate carrying at least one first electrically conductive lead (102, 102') having an interface region connected to at least one second electrically conductive lead (104, 104'), and at least one first ground plane layer (106, 106'),
a second substrate carrying the at least one second electrically conductive lead (104, 104') having an interface region connected to the at least one first electrically conductive lead (102, 102'), and at least one second ground plane layer (108, 108'),
wherein said first and second electrically conductive leads (102, 102'; 104, 104') are arranged on adjacent surfaces of said first and second substrates, and wherein the at least one first ground plane layer (106, 106') is arranged to be electrically insulated from said at least one first conductive lead (102, 102'), and the at least one second ground plane layer (108, 108') is arranged to be electrically insulated from said at least one second conductive lead (104, 104'),
wherein said first and second ground plane layers (106, 106'; 108, 108') are arranged to at least partly overlap each other.

2. Electrical connection interface according to claim 1, wherein at least one of the first and second ground plane layers (106, 106'; 108, 108') is provided with at least one clearance (112, 112').

3. Electrical connection interface according to claim 2, wherein the at least one clearance (112, 112') is arranged and dimensioned in a way that directly adjacent to said interface regions of the first and second electrically conductive leads, no ground plane metallization is present, whereas in an outer peripheral region of the electrical connection interface, at least one narrow grounding strip (118) is formed.

4. Electrical connection interface according to claim 3, wherein said grounding strip (118) in a direction along the conductive leads has a dimension of less than 10 percent of the dimension of the interface region.

5. Electrical connection interface according to one of the preceding claims, wherein a plurality of clearances (112, 112') is provided, each separated from an adjacent one by a grounding web (116).

6. Electrical connection interface according to one of the preceding claims, wherein each substrate carries at least one pair of electrical leads and wherein at least one additional grounding web (120) is arranged to separate individual leads of one pair of electrical leads.

7. Electrical connection interface according to claim 6, wherein the at least one additional grounding web (120) has a tapered region adjacent to an area of said second electrically conductive leads (104) where the conductive leads have a smaller width than at their interface region.

8. Electrical connection interface according to one of the preceding claims, wherein each substrate carries at least one pair of electrical leads and wherein the at least one pair of electrical leads is arranged to be adjacent to a common clearance (112, 112').

9. Electrical connection interface according to one of the preceding claims, wherein the impedance of each first conductive lead (102, 102') is adjusted to match the characteristic impedance of each corresponding second conductive lead (104, 104').

10. Electrical connection interface according to one of the preceding claims, wherein said first and second substrates comprise at least one of a multilayer printed circuit board, PCB, a flexible printed circuit, FPC, or a ceramic circuit carrier.

11. Electrical connection interface according to claim 10, wherein said first and second ground plane layers (106, 106'; 108, 108') are formed by a structured copper layer within or on a surface of said PCB or FPC.

12. Electrical connection interface according to one of the preceding claims, wherein said first and second ground plane layers (106, 106'; 108, 108') are electrically connected to each other by at least one contact point (114) arranged in the overlapping area.

13. Electrical connection interface according to claim 12, wherein said at least one contact point (114, 114') is located adjacent to said interface regions or wherein said at least one contact point (114, 114') is located distanced from said interface regions.

14. Electrical connection interface according to one of the preceding claims, wherein said at least one first and second electrical lead (102, 102'; 104, 104') are connected to each other by means of a solder connection, a press fit connection, or an adhesive.

15. Electrical connection interface according to one of the preceding claims, wherein at least two pairs of first and second electrical leads are arranged in a way that no contact points (114, 114') electrically connecting the first and second ground plane layer (106, 106'; 108, 108') is arranged between them.
